# EUROPÄISCHE PATENTSCHRIFT

(11) **EP 2 718 979 B1**
(45) Veröffentlichungstag und Bekanntmachung des Hinweises auf die Patenterteilung: **27.03.2019**
(21) Anmeldenummer: 12731322.9
(22) Anmeldetag: 04.06.2012
(51) Int. Cl.: H01L 31/0392, H01L 31/0465, H01L 31/18, H01L 27/142

(54) **DÜNNSCHICHT-SOLARMODUL MIT INTEGRIERTER VERSCHALTUNG SOWIE VERFAHREN ZU DESSEN HERSTELLUNG**
THIN FILM SOLAR MODULE HAVING INTEGRATED INTERCONNECTIONS AND METHOD FOR PRODUCING THE SAME
MODULE SOLAIRE À COUCHE MINCE AVEC UNE INTERCONNEXION INTÉGRÉE ET SON PROCÉDÉ DE FABRICATION

(30) Priorität: 07.06.2011 DE 102011103539
(43) Veröffentlichungstag der Anmeldung: 16.04.2014
(73) Patentinhaber: Fraunhofer Gesellschaft zur Förderung der angewandten Forschung E.V., 80686 München (DE); Albert-Ludwigs-Universität Freiburg, 79085 Freiburg (DE)
(72) Erfinder: JANZ, Stefan, 79106 Freiburg (DE); LINDEKUGEL, Stefan, 79211 Denzlingen (DE); REBER, Stefan, 79194 Gundelfingen (DE); JAUS, Joachim, 79100 Freiburg (DE); SCHILLINGER, Kai, 79106 Freiburg (DE); RACHOW, Thomas, 19057 Schwerin (DE); BARTSCH, Jonas, 79106 Freiburg (DE)
(74) Vertreter: Pfenning, Meinig & Partner mbB
(86) Internationale Anmeldenummer: PCT/EP2012/060513
(87) Internationale Veröffentlichungsnummer: WO 2012/168191

(56) Entgegenhaltungen:
- WO-A1-2006/053518
- WO-A1-2010/110510
- WO-A2-2010/012259
- DE-A1- 3 727 826
- DE-A1- 19 715 138
- JP-A- 2002 141 536
- JP-A- 2011 077 246
- US-A- 5 639 314
- US-A1- 2005 070 107
- US-A1- 2007 295 394
- US-A1- 2010 009 492
- T. KUNZ ET AL.: "OPTICAL CHARACTERIZATION OF CRYSTALLINE SILICON THIN-FILM SOLAR CELLS ON FOREIGN SUBSTRATES", THE COMPILED STATE-OF-THE-ART OF PV SOLAR TECHNOLOGY AND DEPLOYMENT : 24TH EUROPEAN PHOTOVOLTAIC SOLAR ENERGY CONFERENCE AND EXHIBITION ; CONFERENCE 21 - 25 SEPTEMBER 2009, EXHIBITION 21 - 24 SEPTEMBER 2009, HAMBURG ; PROCEEDINGS ; EU PVSEC, WIP-RENE, 21. September 2009 (2009-09-21), Seiten 2553-2556, XP040530198, ISBN: 978-3-936338-25-6

## Beschreibung

Die Erfindung betrifft ein Solarmodul auf Dünnschicht-Basis mit integrierter Verschaltung von mindestens zwei Solarzellen, die ein elektrisch nicht-leitfähiges Substrat oder ein elektrisch leitfähiges Substrat mit einer elektrisch nicht-leitfähigen Barriereschicht, auf dem eine Schichtstruktur, die mindestens eine kristalline Halbleiterschicht mit einer ersten Dotierung sowie mindestens eine kristalline Halbleiterschicht mit einer zweiten, zur ersten Dotierung entgegengesetzten Dotierung, abgeschieden ist, enthält. Die Schichtstruktur weist dabei Trenngräben auf, in denen die Emitterkontakte und Basiskontakte abgeschieden sind. Ebenso betrifft die Erfindung ein Verfahren zur Herstellung derartiger Solarmodule.

Der Photovoltaikmarkt weltweit ist derzeit von Solarzellen-Modulen aus kristallinem Wafer-Silicium dominiert. Da die technologische Entwicklung des zugehörigen Zellkonzeptes schon sehr weit fortgeschritten ist, ist der theoretisch mögliche Maximalwirkungsgrad bei Forschungs-Solarzellen bereits zu ca. 90% erreicht. Bei industriell in Serie gefertigten Si-Wafer-Solarzellen wird durch Skalierung und Anpassung der dafür verwendeten Technologien angestrebt, diesen Bestwirkungsgrad zu approximieren. Um einen weiteren Kostenreduktionssprung zu ermöglichen, ist eine grundlegende Änderung des Modulkonzeptes notwendig. Eine vielversprechende Möglichkeit dafür ist das Konzept des integriert verschalteten kristallinen Silicium Dünnschichtmoduls.

Ein derartiges Konzept ist beispielsweise aus der WO 2008/107205 bekannt, in der frontseitig serienverschaltete Solarmodule beschrieben sind.

Dieses Konzept lehnt sich an die existierenden Dünnschichtkonzepte an, die integrierte Serienverschaltungen von streifenförmigen Solarzellen auf einem Glas-Superstrat realisieren. Die Übertragung dieser gängigen Konzepte auf z.B. kristalline Si-Dünnschichtsolarzellen, deren Halbleiterschicht nach dem Verfahren des Zonenschmelzens (RexWE: Rekristallisiertes Waferäquivalent) hergestellt wurde. Dieses besteht darin, eine elektrisch nicht leitende Platte z.B. mittels Atmosphärendruck Gasphasenabscheidung (APCVD) zu verkapseln und z.B. einseitig mit kristallinem Si (ebenfalls APCVD) zu beschichten. Danach wird diese feinkristalline Si Schicht mittels Zonenschmelzen (ZMR) rekristallisiert. Auf diese kristalline Vorlage wiederum wird nun epitaktisch (mit APCVD) Silicium mit einer anderen Dotierung abgeschieden. Hier treten jedoch folgende Probleme auf:
- das RexWE-Verfahren ist ein Substrat-, kein Superstrat-Konzept. Damit muss die Verschaltung von der Vorderseite geschehen, nicht von der Rückseite
- die elektronische Qualität des Halbleiters "kristallines Si" ist um ein vielfaches höher als die der klassischen Dünnschichtsolarzellen (amorphes Si, Cadmiumtellurid, Kupferindiumselenid). Aus diesem Grund darf im Strukturierungsprozess keine Schädigung eingebracht werden, was jedoch bei den klassischen Verfahren der Fall sein kann.
- Höchste Wirkungsgrade zu erhalten, müssen Textur-, Passivierungs-, und lokale Kontaktierungstechniken in das Verschaltungskonzept eingebaut werden. Auch dies ist bei den klassischen Dünnschichttechniken, sowie bei ersten Ansätzen zur Verschaltung von c-Si-Schichtsystemen, nicht durchgehend realisierbar.

Die US 5,639,314 A betrifft eine photovoltaische Vorrichtung mit mehreren miteinander verbundenen photoelektrischen Zellen sowie ein Verfahren zu deren Herstellung. Das Verfahren zum Herstellen der dreidimensional geformten photovoltaischen Vorrichtung umfasst zuerst das Bilden eines photovoltaischen Elements auf einem flexiblen Substrat, vorzugsweise während es flach ist, und dann das Verformen des Substrats, um die dreidimensionale Form zu erreichen. Vorzugsweise wird zuerst eine kristalline photovoltaische Umwandlungsschicht auf dem flachen Substrat gebildet, dann wird die Schicht geschnitten oder geteilt, während das Substrat ungeschnitten bleibt, um eine Vielzahl von getrennten benachbarten photovoltaischen Elementen auf dem Substrat zu bilden, und schließlich wird das Substrat in die dreidimensionale Form verformt.

Das Schneiden kann durch Laserbestrahlung erfolgen. Das Verformen kann durchgeführt werden, indem ein Formgedächtniselement als das Substrat bereitgestellt wird oder ein Formgedächtniselement auf das Substrat gebondet wird und dann das Formgedächtniselement in seine zuvor gespeicherte dreidimensionale Form zurückgeführt wird. Die benachbarten photovoltaischen Elemente können elektrisch in Reihe miteinander verbunden werden, indem Bonddrähte oder ein isolierender Film und dann ein leitender Film in den geschnittenen Bereichen zwischen benachbarten photovoltaischen Elementen aufgebracht werden.

Ausgehend hiervon war es Aufgabe der vorliegenden Erfindung, Solarmodule mit integrierter Verschaltung und gleichzeitig möglichst geringem Materialabtrag herzustellen, wobei die Herstellung einfach zu handhaben und schnell durchzuführen sein soll.

Diese Aufgabe wird durch das Solarmodul mit den Merkmalen des Anspruchs 1 sowie durch das Verfahren zur Herstellung von Solarmodulen mit den Merkmalen des Anspruchs 5 gelöst. Die weiteren abhängigen Ansprüche zeigen vorteilhafte Weiterbildungen auf.

Erfindungsgemäß wird ein Solarmodul auf Dünnschicht-basis mit integrierter Verschaltung von mindestens zwei Solarzellen bereitgestellt, das
a) ein elektrisch nicht-leitfähiges Substrat; oder
b) ein elektrisch leitfähiges Substrat;
mit einer elektrisch nicht-leitfähigen Barriereschicht, auf dem eine Schichtstruktur, die mindestens eine kristalline Halbleiterschicht mit einer ersten Dotierung sowie mindestens eine kristalline Halbleiterschicht mit einer zweiten, zur ersten Dotierung entgegengesetzten Dotierung enthält, abgeschieden ist, enthält. Dabei weist das Solarmodul isolierende Trenngräben zwischen den einzelnen Solarzellen auf. Dabei ist in den Trenngräben die Schichtstruktur entfernt. Zumindest in einem Teil der Trenngräben und zumindest auf Bereichen der Schichtstruktur sind mindestens ein Emitterkontakt und mindestens ein Basiskontakt mittels Gasphasenabscheidung, Spritzen, Sputtern, Drucken oder Aufdampfverfahren abgeschieden.

Erfindungsgemäß weisen die Trenngräben eine Flankenisolation in Form einer gedruckten, aufgedampften, abgeschiedenen oder gewachsenen nitridischen oder carbidischen Schicht auf.

Erfindungsgemäß ist das Substrat im Ganzen mit der Barriereschicht vollständig verkapselt, wobei die Barriereschicht aus einer nitridischen Schicht oder einer carbidischen Schicht oder Kombinationen hiervon besteht oder diese im Wesentlichen enthält, wobei die Barriereschicht eine Dicke von 100 nm bis 100 µm aufweist.

Erfindungsgemäß weist die Schichtstruktur eine frontseitige Isolationsschicht auf, die eine Passivierungsschicht darstellt.

Unter Abscheidung im Sinne der vorliegenden Erfindung werden neben einer Gasphasenabscheidung ebenso eine gespritzte Aufbringung, Druckverfahren sowie Aufdampfverfahren verstanden.

Die vorliegende Erfindung basiert somit auf einer neuen Solarzellen-Architektur einer integrierten Verschaltung des wenige µm dünnen Siliziumschichtstapels auf dem Substrat. Dabei werden Techniken zum Ablatieren und Trennen des Schichtstapels sowie zu dessen Texturierung, Passivierung, Isolierung und Verschaltung eingesetzt. Bei der vorliegenden Erfindung sind daher die folgenden Aspekte hervorzuheben:
- Effektiv texturierte Solarzellenvorderseite bei geringem Materialabtrag
- Sehr effiziente Passivierung der Solarzellenfrontseite sowie der offenen Flanken der Schicht durch eine Passivierungs- und Antireflexionsschicht
- Schädigungsarme Herstellung eines isolierenden Trenngrabens
- Schädigungsarmes Freilegen des Basismaterials
- Verschattungsarme Metallkontakte zur Serienverschaltung von Einzelstreifen
- Rekombinationsarme Metallkontakte durch lokale, punkt- oder streifenförmige Metallkontakte, unter denen die Si-Schicht zur weiteren Verminderung der Rekombination hochdotiert ist.
- Möglichkeit, integrierte Bypassdioden zu jeder Einzelzelle zu realisieren, die das Modul vor Zerstörung schützen und den Stromertrag optimieren.

Ein weiterer wesentlicher Vorteil des erfindungsgemäßen Konzeptes basiert auf der integrierten Verschaltung der von der Fläche völlig variablen Solarzellen, da man von einer durchgängigen Substratfläche ausgeht und diese völlig frei in Solarzellenfelder einteilt. Durch die spezielle Solarzellen- und Verschaltungsarchitektur können für kristalline Silizium sehr hohe Wirkungsgrade erzielt werden, welche zudem kostengünstig realisiert werden können, da bereits die gesamte Modulfläche prozessiert werden kann.

Die vorliegende Erfindung weist dabei gegenüber der aus dem Stand der Technik bekannten Silizium-Wafer-Technologie folgende Vorteile auf:
- Einsatz sehr geringer Mengen von hochreinem kristallinem Si (nur wenige µm) bei trotzdem sehr hoher mechanischer Stabilität durch das Substrat,
- Einfache Variation der Zellflächen für das optimale Strom/Spannungsverhältnis im Modul,
- Großes Kostenreduktionspotential durch höheren Durchsatz und Ausbeute bei der Modulverschaltung sowie Einsparungen von Sekundärmaterialien wie zum Beispiel Glas, Backsheet oder Rahmenmaterialien,
- Höhere Kundenakzeptanz durch homogeneres Erscheinungsbild.

Vorzugsweise besteht das Substrat aus einem Material ausgewählt aus der Gruppe der Zirkonsilikate, Graphite, Glaskeramiken, Silikatkeramiken, Oxidkeramiken, insbesondere Aluminiumoxid, Titanoxid oder Siliciumoxid, Nitridkeramiken, insbesondere Siliciumnitrid oder Titannitrid, Mulliten, Porzellan, Sintersilicium, Sintermetalle sowie deren Verbunde oder enthält diese im Wesentlichen.

In den Bereichen des Solarmoduls der isolierenden Trenngräben ist die Schichtstruktur vorzugsweise durch Ablation, besonders bevorzugt mittels Flüssigkeitsstrahl-geführtem Laser (LCP) oder Trockenlaser entfernt.

Eine weitere bevorzugte Variante sieht vor, dass mindestens ein Trenngraben eine Bypassdiode definiert. Diese ermöglichen es im Falle des Defektes einer Solarzelle, dass diese Solarzelle überbrückt werden kann, so dass die Funktion des Solarmoduls im Ganzen nicht eingeschränkt wird. Die Bypassdiode ist dabei vorzugsweise über elektrische Kontakte mit dem Emitter-Kontakt und dem Basis-Kontakt verbunden.

Erfindungsgemäß weist das Solarmodul im Bereich der Trenngräben eine oder mehrere Flankenisolationen, vorzugsweise zur Verhinderung von Kurzschlüssen, auf.

Erfindungsgemäß ist vorgesehen, dass die Schichtstruktur zusätzlich eine frontseitige Isolationsschicht aufweist. Erfindungsgemäß besitzt die frontseitige Isolationsschicht auch noch die Funktion einer Passivierungsschicht.

Die Barriereschicht besteht erfindungsgemäß aus einer nitridischen Schicht, insbesondere Bornitrid oder Siliciumnitrid, oder einer carbidischen Schicht, insbesondere Siliciumcarbid oder Titancarbid, oder Kombinationen hiervon oder enthält diese im Wesentlichen.

Erfindungsgemäß ist das Substrat im Ganzen mit der Barriereschicht vollständig verkapselt.

Erfindungsgemäß wird ebenso ein Verfahren zur Herstellung eines Solarmoduls auf Dünnschicht-Basis mit integrierter Verschaltung von mindestens zwei Solarzellen bereitgestellt, das die folgenden Verfahrensschritte aufweist:
a) Bereitstellung
   i) eines elektrisch nicht-leitfähigen Substrats; oder
   ii) eines elektrisch leitfähigen Substrats (bevorzugt 100-5000 µm Dicke) mit einer elektrisch nicht-leitfähigen Barriereschicht (100 nm bis 100 µm Dicke) mit darauf, bevorzugt mittels Atmosphärendruck-CVD, abgeschiedener und, bevorzugt teilweise mittels Zonenschmelzverfahren (ZMR) rekristallisierter, Schichtstruktur, die mindestens eine kristalline Halbleiterschicht (bevorzugt 0,1-50 µm Dicke) mit einer ersten Dotierung von z.B. 1x10¹⁶-5x10¹⁹ cm⁻³ Bor sowie mindestens eine kristalline Halbleiterschicht mit einer zweiten, zur ersten Dotierung entgegengesetzten Dotierung von z.B. 1x10¹⁸-2x10²⁰ cm⁻³ Phosphor enthält,
b) bereichsweise Entfernung der Schichtstruktur vom Substrat zur Erzeugung von isolierenden Trenngräben, vorzugsweise mit einer Breite von 10-1000 µm, und
c) Abscheiden des Emitterkontaktes, vorzugsweise aus Silber, und des Basiskontaktes, vorzugsweise aus Aluminium, und bevorzugt mit einer Dicke von 1-10 µm in zumindest einem Teil der Trenngräben und zumindest auf Bereichen der Schichtstruktur.

Erfindungsgemäß erfolgt vor Schritt c) eine Flankenisolation mittels einer gedruckten, aufgedampften, abgeschiedenen oder gewachsenen nitridischen oder carbidischen Schicht.

Erfindungsgemäß wird das Substrat im Ganzen mit der Barriereschicht vollständig verkapselt, wobei die Barriereschicht aus einer nitridischen Sicht oder einer carbidischen Schicht oder Kombinationen hiervon besteht oder diese im Wesentlichen enthält, wobei die Barriereschicht eine Dicke von 100 nm bis 100 µm aufweist.

Erfindungsgemäß wird zwischen Schritt b) und c) eine frontseitige Isolationsschicht auf der Halbleiterschicht abgeschieden, die eine Passivierungsschicht darstellt.

Vorzugsweise wird nach Schritt a) eine Texturierung des Substrats mit darauf abgeschiedener Schichtstruktur durchgeführt. Dies wird bevorzugt durch Plasmatextur, Gasphasentextur oder nasschemische Textur umgesetzt.

Eine weitere bevorzugte Ausführungsform sieht vor, dass die Entfernung der Schichtstruktur in Schritt b) mittels Ablation erfolgt. Hierbei sind besonders flüssigkeitsstrahlgeführte Laser-Verfahren (LCP) oder Trockenlaser-Verfahren bevorzugt.

Die Emitterkontakte und Basiskontakte können vorzugsweise mittels Aufdampfen, Drucken oder Sputtern von Metallen mit anschließendem Feuern der Kontakte zur Kontaktherstellung, insbesondere mit einem RTP-Ofen oder durch Laserfeuern erfolgen.

Erfindungsgemäß wird zwischen Schritt b) und c) eine frontseitige Isolationsschicht auf der Halbleiterschicht abgeschieden.

Die Herstellung der mindestens einen frontseitigen Isolationsschicht erfolgt vorzugsweise mittels thermischer Oxidation von Silizium oder durch Abscheidung mittels plasmaverstärkter chemischer Gasphasenabscheidung (PECVD) oder Atomlagenabscheidung (ALD).

Vor der Abscheidung der Isolationsschicht kann vorzugsweise mittels eines Laserschnittes eine Unterbrechung der oberen Halbleiterschicht, d.h. der Schicht mit der zweiten Dotierung, erreicht werden. Dieser Laserschnitt wird vorzugsweise mittels Flüssigkeitsstrahl-geführtem Laser (LCP) oder Trockenlaser erzeugt.

Erfindungsgemäß erfolgt vor Schritt c) eine Flankenisolation. Diese Flankenisolation wird erfindungsgemäß mittels einer gedruckten, aufgedampften, abgeschiedenen oder gewachsenen nitridischen oder carbidischen Schicht realisiert.

Eine weitere bevorzugte Ausführungsform sieht vor, dass in mindestens einem Trenngraben eine Bypass-Diode integriert wird, die über elektrische Kontakte mit dem Emitter und der Basis verbunden werden.

Anhand des nachfolgenden Beispiels und der nachfolgenden Figuren soll der erfindungsgemäße Gegenstand näher erläutert werden, ohne diesen auf die hier gezeigten spezifischen Ausführungsformen einschränken zu wollen.
- Fig. 1: zeigt in einer schematischen Schnittdarstellung einen ersten Gegenstand.
- Fig. 2: zeigt in einer schematischen Schnittdarstellung einen erfindungsgemäßen Gegenstand.
- Fig. 3: zeigt eine Draufsicht eines erfindungsgemäßen Solarmoduls.

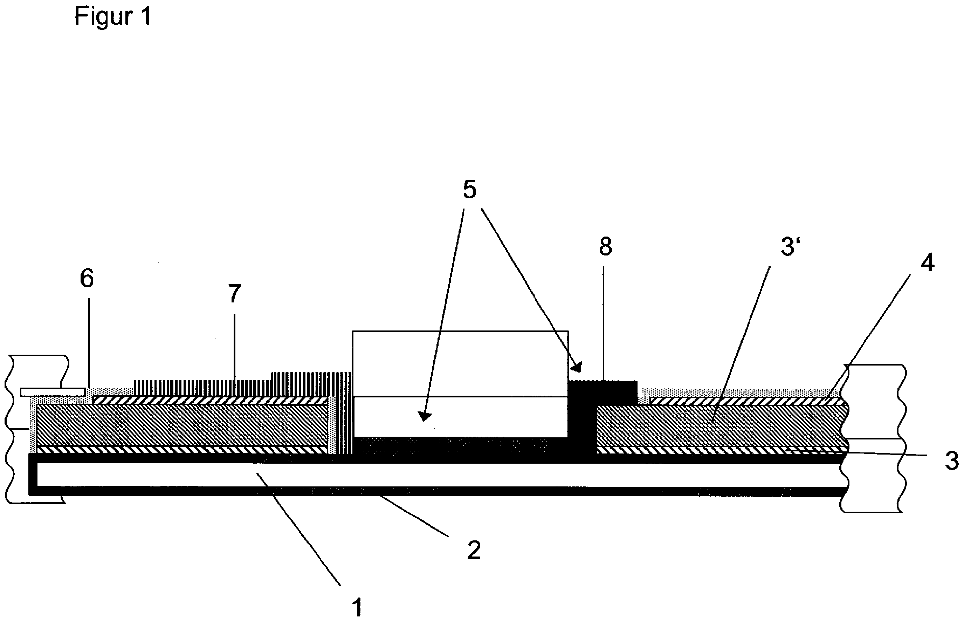

In Fig. 1 ist ein erstes Solarmodul auf Dünnschicht-Basis mit integrierter Verschaltung von zwei Solarzellen im Querschnitt dargestellt. Hierin ist ein Substrat 1, das sowohl elektrisch leitend als auch elektrisch nicht-leitend sein kann, vollständig von einer Verkapselungsschicht 2, die im vorliegenden Fall elektrisch nicht-leitend ist, umgeben. Auf der Verkapselungsschicht 2 ist eine Schichtstruktur abgeschieden, die aus einer hochdotierten Schicht 3, einer normal dotierten Schicht 3' und einer zur Schicht 3 entgegengesetzt hoch dotierten Schicht 4 aus kristallinem Silizium abgeschieden wird. Gleichzeitig ist die Schichtstruktur unterbrochen durch einen Trenngraben 5, der durch Ablation entfernt wurde. Im Trenngraben 5 sowie bereichsweise auf der Schichtstruktur sind der Emitterkontakt 7 und der Basiskontakt 8 abgeschieden. Weiterhin ist frontseitig zur Schichtstruktur noch eine Isolationsschicht bzw. Passivierungsschicht 6 abgeschieden.

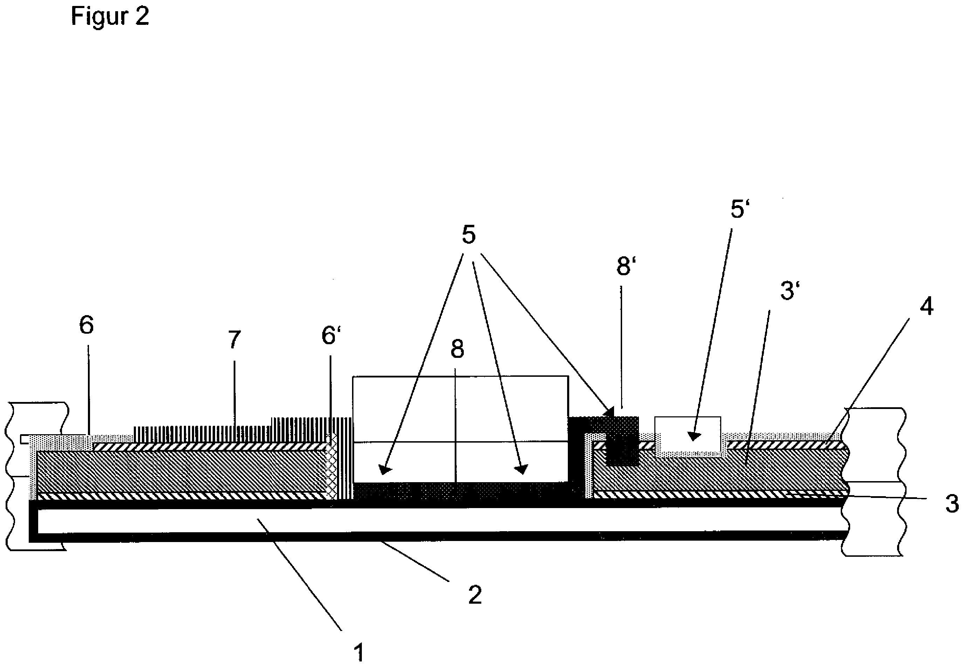

In Fig. 2 ist eine Variante des erfindungsgemäßen Solarmoduls auf Dünnschicht-Basis dargestellt. Der Aufbau von Substrat und Schichtstruktur entspricht hier der Figur 1. Zusätzlich ist in Fig. 2 noch eine Unterbrechung der Schichtstruktur mittels eines Laserschnitts 5' dargestellt. Ebenso zusätzlich weist die linke Solarzelle am Rand des Trenngrabens eine Flankenisolation 6' auf. Der Basiskontakt 8 zeigt zusätzlich einen lasergefeuerten Kontakt 8'.

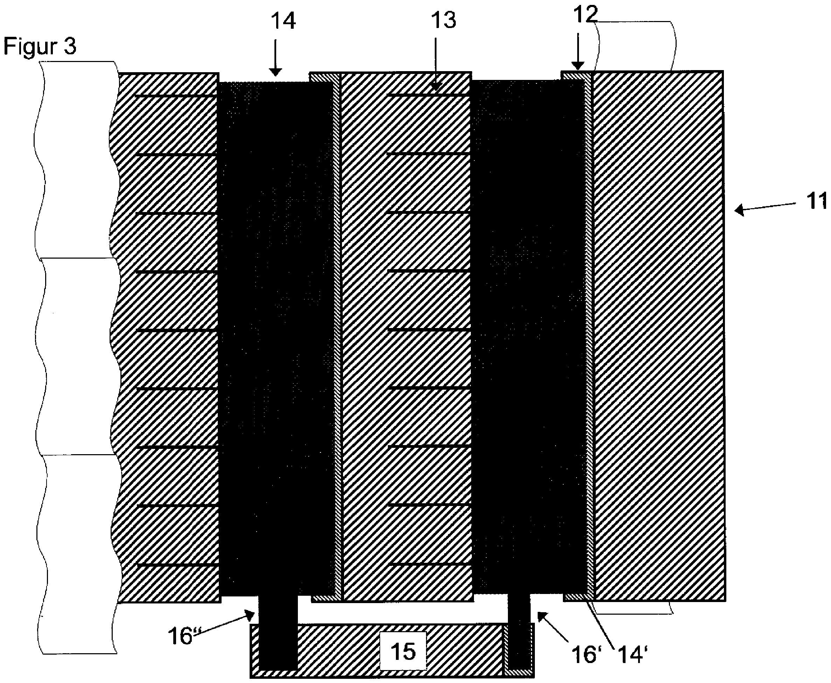

In Fig. 3 ist eine Draufsicht eines erfindungsgemäßen Solarmoduls dargestellt. Hier sind die Basis 11 und der Emitter 12 der einzelnen Solarzellen dargestellt. Ebenso zeigt die Abbildung Metallfinger zur Emitterkontaktierung 13. Der Basiskontakt 14 weist lasergefeuerte Kontakte 14' auf. Zusätzlich ist eine Bypassdiode 15 integriert, die über die Kontakte 16' und 16" mit den Basiskontakten 14 verbunden ist.

### Beispiel

Im Folgenden wird eine mögliche Prozessfolge zur Herstellung eines integriert verschalteten kristallinen Si-Dünnschichtmoduls mit einigen Zusatzoptionen dargestellt:
1. Textur der Silicium Oberfläche mittels Plasmatextur
2. c-Si Ablation des gesamten Si-Stapels (14-50 µm) zur Zelltrennung mit geringer Oberflächenschädigung mittels LCP
3. Gezielte Ablation (0.1 bis 40 µm tief) des Emitters auf einer Breite von etwa 10-500 µm mit geringer Schädigung mittels LCP-Laser
4. Laserschnitt mittels LCP-Laser
5. Passivieren aller Silicium Oberflächen thermische Oxidation
6. Flankenisolation mittels oxidischer Inkjetpaste
7. Kontaktfinger am Emitter durch Aufdampfen von Metallen
8. Basiskontakt durch Aufdampfen von Metallen
9. Feuern der Kontakte im RTP Ofen
10. Laser-gefeuerte Kontakte am Basiskontakt Alternativ kann der Schritt 1 nach dem Schritt 3 durchgeführt werden, mit dem Vorteil, dass die Schritte 2 und 3 durch Nachätzen eventuell verbliebener Reste unterstützt werden können. Falls der Schichtaufbau bereits texturiert ist, oder keine Textur benötigt wird, weil z.B. ein effizienter diffuser Rückseitenspiegel auf Schicht 1 oder 2 eingebaut wurde, kann Schritt 1 auch ersatzlos entfallen.

## Patentansprüche

1. Solarmodul auf Dünnschicht-Basis mit integrierter Verschaltung von mindestens zwei Solarzellen enthaltend
a) ein elektrisch nicht-leitfähiges Substrat (1); oder
b) ein elektrisch leitfähiges Substrat (1);
mit einer elektrisch nicht-leitfähigen Barriereschicht (2), auf dem eine Schichtstruktur, die mindestens eine kristalline Halbleiterschicht (3) mit einer ersten Dotierung sowie mindestens eine kristalline Halbleiterschicht (4) mit einer zweiten, zur ersten Dotierung entgegengesetzten Dotierung, abgeschieden ist,
wobei das Solarmodul isolierende Trenngräben (5), in denen die Schichtstruktur entfernt ist, zwischen den einzelnen Solarzellen aufweist und wobei zumindest in einem Teil der Trenngräben (5) und zumindest auf Bereichen der Schichtstruktur ein Emitterkontakt (7) und ein Basiskontakt (8) mittels Gasphasenabscheidung, Spritzen, Sputtern, Drucken oder Aufdampfverfahren abgeschieden sind, **dadurch gekennzeichnet, dass** die Trenngräben eine Flankenisolation (6') in Form einer gedruckten, aufgedampften, abgeschiedenen oder gewachsenen nitridischen oder carbidischen Schicht aufweisen,
wobei das Substrat im Ganzen mit der Barriereschicht vollständig verkapselt ist,
wobei die Barriereschicht aus einer nitridischen Schicht oder einer carbidischen Schicht oder Kombinationen hiervon besteht oder diese im Wesentlichen enthält,
wobei die Barriereschicht eine Dicke von 100 nm bis 100 µm aufweist, und
wobei die Schichtstruktur eine frontseitige Isolationsschicht (6) aufweist, die eine Passivierungsschicht darstellt.

2. Solarmodul nach Anspruch 1, **dadurch gekennzeichnet, dass** das Substrat aus einem Material ausgewählt aus der Gruppe der Zirkonsilikate, Graphite, Glaskeramiken, Silikatkeramiken, Oxidkeramiken, insbesondere Aluminiumoxid, Titanoxid oder Siliciumoxid, Nitridkeramiken, insbesondere Siliciumnitrid oder Titannitrid, Mulliten, Porzellan, Sintersilicium, Sintermetalle sowie deren Verbunde besteht oder dieses im Wesentlichen enthält und/oder die Barriereschicht aus Bornitrid oder Siliciumnitrid, Siliciumcarbid oder Titancarbid, oder Kombinationen hiervon besteht oder diese im Wesentlichen enthält.

3. Solarmodul nach einem der vorhergehenden Ansprüche, **dadurch gekennzeichnet, dass** mindestens ein weiterer Trenngraben (5) eine integrierte Bypass-Diode (15) definiert, die über elektrische Kontakte (11, 12) mit dem Emitterkontakt (7) und dem Basiskontakt (8) verbunden sind.

4. Solarmodul nach einem der vorhergehenden Ansprüche, **dadurch gekennzeichnet, dass** das elektrisch nicht-leitfähige Substrat (1) mit der Barriereschicht (2) vollständig verkapselt ist.

5. Verfahren zur Herstellung eines Solarmoduls auf Dünnschicht-Basis mit integrierter Verschaltung von mindestens zwei Solarzellen, mit folgenden Schritten:
a) Bereitstellung eines
i) elektrisch nicht-leitfähigen Substrats (1); oder
ii) eines elektrisch leitfähigen Substrats (1);
mit einer elektrisch nicht-leitfähigen Barriereschicht (2) mit darauf abgeschiedener Schichtstruktur, die mindestens eine kristalline Halbleiterschicht (3) mit einer ersten Dotierung sowie mindestens eine kristalline Halbleiterschicht (4) mit einer zweiten, zur ersten Dotierung entgegengesetzten Dotierung enthält,
b) bereichsweise Entfernung der Schichtstruktur vom Substrat zur Erzeugung von isolierenden Trenngräben, und
c) Abscheiden des Emitterkontaktes (7) und des Basiskontaktes (8) in zumindest einem Teil der Trenngräben und zumindest auf Bereichen der Schichtstruktur,
**dadurch gekennzeichnet, dass** vor Schritt c) eine Flankenisolation erfolgt,
dass das Substrat im Ganzen mit der Barriereschicht vollständig verkapselt ist,
dass die Barriereschicht aus einer nitridischen Schicht oder einer carbidischen Schicht oder Kombinationen hiervon besteht oder diese im Wesentlichen enthält,
dass die Barriereschicht eine Dicke von 100 nm bis 100 µm aufweist,
dass zwischen Schritt b) und c) eine frontseitige Isolationsschicht (6) auf der Halbleiterschicht (4) abgeschieden wird, die eine Passivierungsschicht darstellt, und
dass vor Schritt c) die Flankenisolation mittels einer gedruckten, aufgedampften, abgeschiedenen oder gewachsenen nitridischen oder carbidischen Schicht erfolgt.

6. Verfahren nach Anspruch 5, **dadurch gekennzeichnet, dass** nach Schritt a) eine Texturierung des Substrats (1) mit darauf abgeschiedener Schichtstruktur, insbesondere eine Plasmatextur, eine Gasphasentextur oder eine nasschemische Textur, erfolgt.

7. Verfahren nach einem der Ansprüche 5 oder 6, **dadurch gekennzeichnet, dass** die Entfernung der Schichtstruktur in Schritt b) mittels Ablation erfolgt, insbesondere mittels flüssigkeitsstrahl-geführtem Laser (LCP) oder Trockenlaser.

8. Verfahren nach einem der Ansprüche 5 bis 7, **dadurch gekennzeichnet, dass** die Herstellung der mindestens einen frontseitigen Isolationsschicht (6) mittels thermischer Oxidation von Silicium oder durch Abscheidung mittels plasmaverstärkter chemischer Gasphasenabscheidung (PECVD) oder Atomlagenabscheidung (ALD) erfolgt.

9. Verfahren nach einem der Ansprüche 5 bis 8, **dadurch gekennzeichnet, dass** die Erzeugung des Emitterkontaktes (7) und des Basiskontaktes (8) mittels Aufdampfen, Drucken oder Sputtern von Metallen mit anschließendem Feuern der Kontakte zur Kontaktherstellung, insbesondere mit einem RTP-Ofen oder durch Laserfeuern erfolgt.

10. Verfahren nach einem der Ansprüche 5 bis 9, **dadurch gekennzeichnet, dass** nach Schritt b) ein Laserschnitt mittels flüssigkeitsstrahl-geführtem Laser (LCP) oder Trockenlaser erfolgt.

11. Verfahren nach einem der Ansprüche 5 bis 10 zur Herstellung eines Solarmoduls nach einem der Ansprüche 1 bis 4.

## Claims

1. Thin-film solar module with integrated wiring of at least two solar cells comprising
a) an electrically non-conductive substrate (1); or
b) an electrically conductive substrate (1);
having an electrically non-conductive barrier layer (2) on which a layer structure, which comprises at least one crystalline semiconductor layer (3) with a first doping and also at least one crystalline semiconductor layer (4) with a second doping opposite the first doping, is deposited,
the solar module having insulating separating channels (5), in which the layer structure is removed, between the individual solar cells and, at least in a part of the separating channels (5) and at least on regions of the layer structure, an emitter contact (7) and a base contact (8) being deposited by means of vapour-phase deposition, injection, sputtering, printing or evaporation coating methods, **characterised in that** the separating channels have an edge insulation (6') in the form of a printed, evaporation-coated, deposited or grown nitride or carbide layer,
the substrate being completely encapsulated in its entirety by the barrier layer,
the barrier layer consisting of a nitride layer or a carbide layer or combinations hereof or essentially comprising these,
the barrier layer having a thickness of 100 nm to 100 µm, and
the layer structure having a front-side insulation layer (6) which represents a passivation layer.

2. Solar module according to claim 1, **characterised in that** the substrate consists of a material selected from the group of zirconium silicates, graphites, glass ceramics, silicate ceramics, oxide ceramics, in particular aluminium oxide, titanium oxide or silicon oxide, nitride ceramics, in particular silicon nitride or titanium nitride, mullites, porcelain, sintered silicon, sintered metals and also composites thereof or essentially comprises these and/or the barrier layer consists of boron nitride or silicon nitride, silicon carbide or titanium carbide, or combinations hereof or essentially comprises these.

3. Solar module according to one of the preceding claims, **characterised in that** at least one further separating channel (5) defines an integrated bypass diode (15) which are connected via electrical contacts (11, 12) to the emitter contact (7) and to the base contact (8).

4. Solar module according to one of the preceding claims, **characterised in that** the electrically non-conductive substrate (1) is completely encapsulated by the barrier layer (2).

5. Method for the production of a thin-film solar module having integrated wiring of at least two solar cells, with the following steps:
a) providing an
i) electrically non-conductive substrate (1); or
ii) an electrically conductive substrate (1);
having an electrically non-conductive barrier layer (2) with a layer structure deposited thereon, which comprises at least one crystalline semiconductor layer (3) with a first doping and also at least one crystalline semiconductor layer (4) with a second doping opposite the first doping,
b) removing, in regions, the layer structure from the substrate in order to produce insulating separating channels, and
c) depositing the emitter contact (7) and the base contact (8) in at least one part of the separating channels and at least on regions of the layer structure,
**characterised in that**, before step c), an edge insulation is effected,
**in that** the substrate is completely encapsulated in its entirety by the barrier layer,
**in that** the barrier layer consists of a nitride layer or a carbide layer or combinations hereof or essentially comprises these,
**in that** the barrier layer has a thickness of 100 nm to 100 µm,
**in that**, between step b) and c), a front-side insulation layer (6), which represents a passivation layer, is deposited on the semiconductor layer (4) and
**in that**, before step c), the edge insulation is effected by means of a printed, evaporation-coated, deposited or grown nitride or carbide layer.

6. Method according to claim 5, **characterised in that**, after step a), texturing of the substrate (1) is effected with a layer structure deposited thereon, in particular a plasma texture, a vapour-phase texture or a wet-chemical texture.

7. Method according to one of the claims 5 or 6, **characterised in that**, in step b), removal of the layer structure is effected by means of ablation, in particular by means of liquid-jet-guided laser (LCP) or dry laser.

8. Method according to one of the claims 5 to 7, **characterised in that** production of the at least one front-side insulation layer (6) is effected by means of thermal oxidation of silicon or by deposition by means of plasma-enhanced chemical vapour-phase deposition (PECVD) or atomic layer deposition (ALD).

9. Method according to one of the claims 5 to 8, **characterised in that** production of the emitter contact (7) and of the base contact (8) is effected by means of evaporation coating, printing or sputtering of metals with subsequent firing of the contacts for the contact production, in particular with an RTP furnace or by laser firing.

10. Method according to one of the claims 5 to 9, **characterised in that**, after step b), a laser cut is effected by means of liquid-jet-guided laser (LCP) or dry laser.

11. Method according to one of the claims 5 to 10 for the production of a solar module according to one of the claims 1 to 4.

## Revendications

1. Module photovoltaïque à base de couches minces avec un câblage intégré d'au moins deux cellules photovoltaïques, contenant
a) un substrat non électro-conducteur (1) ; ou
b) un substrat électro-conducteur (1) ;
avec une couche barrière non électro-conductrice (2), sur lequel est déposée une structure en couches, qui comprend au moins une couche semi-conductrice cristalline (3) avec un premier dopage ainsi qu'au moins une couche semi-conductrice cristalline (4) avec un deuxième dopage opposé au premier dopage,
le module photovoltaïque comprenant des fosses de séparation isolantes (5), dans lesquelles la structure en couches est éliminée, entre les cellules photovoltaïques et, au moins dans une partie des fosses de séparation (5) et au moins sur des zones de la structure en couches, un contact émetteur (7) et un contact de base (8) sont déposés par un dépôt en phase gazeuse, par injection, par pulvérisation, impression ou vaporisation, **caractérisé en ce que** les fosses de séparation comprennent une isolation des flancs (6') sous la forme d'une couche nitrurée ou carburée imprimée, vaporisée, déposée ou germée,
le substrat dans son ensemble étant entièrement encapsulé avec la couche barrière,
la couche barrière étant constituée d'une couche nitrurée ou d'une couche carburée ou d'une combinaison de celles-ci ou contenant essentiellement celles-ci,
la couche barrière présentant une épaisseur de 100 nm à 100 µm et
la structure en couches comprenant une couche d'isolation frontale (6) qui constitue une couche de passivation.

2. Module photovoltaïque selon la revendication 1, **caractérisé en ce que** le substrat est constitué d'un matériau sélectionné dans le groupe constitué de silicates de zirconium, de graphites, de céramiques vitreuses, des céramiques de types silicates, de céramiques de types oxydes, plus particulièrement de l'oxyde d'aluminium, de l'oxyde de titane ou de l'oxyde de silicium, de céramiques de type nitrure, plus particulièrement du nitrure de silicium ou du nitrure de titane, de mullites, de porcelaine, de silicium fritté, de métaux frittés ainsi que leurs composés ou contient essentiellement ceux-ci et/ou la couche barrière est constitué de nitrure de bore ou de nitrure de silicium, de carbure de silicium ou de carbure de titane ou de combinaisons de ceux-ci ou contient essentiellement ceux-ci.

3. Module photovoltaïque selon l'une des revendications précédentes, **caractérisé en ce qu'**au moins une fosse de séparation (5) supplémentaire définit une diode de dérivation intégrée (15), qui est reliée par l'intermédiaire de contacts électriques (11, 12) avec le contact émetteur (7) et le contact de base (8).

4. Module photovoltaïque selon l'une des revendications précédentes, **caractérisé en ce que** le substrat non électro-conducteur (1) est encapsulé entièrement avec la couche barrière (2).

5. Procédé de fabrication d'un module photovoltaïque à base de couches minces avec un câblage intégré d'au moins deux cellules photovoltaïques, avec les étapes suivantes :
a) préparation
i) d'un substrat non électro-conducteur (1) ; ou
ii) d'un substrat électro-conducteur (1) ;
avec une couche barrière non électro-conductrice (2) avec une structure en couches déposée dessus, qui contient au moins une couche semi-conductrice cristalline (3) avec un premier dopage ainsi qu'au moins une couche semi-conductrice cristalline (4) avec un deuxième dopage opposé au premier dopage,
b) élimination, à certains endroits, de la structure en couches du substrat pour la réalisation de fosses de séparation isolantes et
c) dépôt du contact émetteur (7) et du contact de base (8) dans au moins une partie des fosses de séparation et au moins sur des parties de la structure en couches, **caractérisé en ce que**, avant l'étape c), une isolation des flancs a lieu,
le substrat dans son ensemble est entièrement encapsulé avec la couche barrière,
la couche barrière est constituée d'une couche nitrurée ou d'une couche carburée ou de combinaisons de celles-ci ou contient essentiellement celles-ci,
la couche barrière présente une épaisseur de 100 nm à 100 µm,
entre les étapes b) et c), une couche d'isolation frontale (6) est déposée sur la couche semi-conductrice (4), qui constitue une couche de passivation et
avant l'étape c), l'isolation des flancs a lieu au moyen d'une couche nitrurée ou carburée imprimée, vaporisée, déposée ou germée.

6. Procédé selon la revendication 5, **caractérisé en ce que**, après l'étape a), une texturation du substrat (1) est réalisée avec une structure en couches déposée dessus, plus particulièrement une texture au plasma, une texture à phase gazeuse ou une texture par voie chimique humide.

7. Procédé selon l'une des revendications 5 ou 6, **caractérisé en ce que** l'élimination de la structure en couches a lieu à l'étape b) au moyen d'une ablation, plus particulièrement au moyen d'un laser guidé par un jet de liquide (LCP) ou d'un laser à sec.

8. Procédé selon l'une des revendications 5 à 7, **caractérisé en ce que** la réalisation de l'au moins une couche d'isolation frontale (6) a lieu au moyen d'une oxydation thermique de silicium ou par le dépôt au moyen d'un dépôt chimique en phase gazeuse renforcée par un plasma (PECVD) ou d'un dépôt de couches d'atomes (ALD).

9. Procédé selon l'une des revendications 5 à 8, **caractérisé en ce que** la réalisation du contact émetteur (7) et du contact de base (8) a lieu par vaporisation, impression ou pulvérisation de métaux avec une combustion des contacts pour l'établissement du contact, plus particulièrement avec un four RTP ou par combustion laser.

10. Procédé selon l'une des revendications 5 à 9, **caractérisé en ce que**, après l'étape b), une découpe laser a lieu au moyen d'un laser guidé par un jet de liquide (LCP) ou d'un laser à sec.

11. Procédé selon l'une des revendications 5 à 10, pour la fabrication d'un module photovoltaïque selon l'une des revendications 1 à 4.
